# EUROPÄISCHE PATENTSCHRIFT

(11) **EP 3 344 939 B1**
(45) Veröffentlichungstag und Bekanntmachung des Hinweises auf die Patenterteilung: **11.09.2019**
(21) Anmeldenummer: 16738109.4
(22) Anmeldetag: 07.07.2016
(51) Int. Cl.: F27D 19/00, F27D 21/00, F27D 21/02, C21B 7/16, C21B 5/00, F27B 1/26, F27B 1/28

(54) **HOCHOFEN MIT ENERGIEAUTARKER BEOBACHTUNG VON KOHLENSTOFFEINBLASUNG**
BLAST FURNACE HAVING ENERGY-SELF-SUFFICIENT MONITORING OF CARBON INJECTION
HAUT FOURNEAU MUNI D'UN DISPOSITIF AUTOSUFFISANT D'OBSERVATION DE L'INJECTION DE CARBONE

(30) Priorität: 02.09.2015 AT 507502015
(43) Veröffentlichungstag der Anmeldung: 11.07.2018
(73) Patentinhaber: Primetals Technologies Austria GmbH, 4031 Linz (AT)
(72) Erfinder: FISCHER, Paul, 4040 Linz (AT); KUEHAS, Thomas, 4225 Luftenberg (AT); ROHRHOFER, Andreas, 4020 Linz (AT); SCHÖNEGGER, Christoph, 4063 Hörsching (AT)
(74) Vertreter: Metals@Linz
(86) Internationale Anmeldenummer: PCT/EP2016/066095
(87) Internationale Veröffentlichungsnummer: WO 2017/036644

(56) Entgegenhaltungen:
- WO-A1-2014/203509
- WO-A1-2015/015936
- CN-U- 202 881 302
- KR-A- 20100 071 349
- LU-A1- 90 610

## Beschreibung

Die vorliegende Erfindung geht aus von einem Hochofen.

Aus der WO 2009/141 419 A1 und der WO 2015/015936 A1 ist ein Hochofen bekannt,
- wobei der Hochofen eine schachtförmige Ofenwand aufweist, die einen Prozessraum umschließt, in dem Eisenerz zu Eisen verhüttet wird,
- wobei die Ofenwand an ihrem Umfang Öffnungen aufweist, über welche dem Prozessraum Heißwind zugeführt wird,
- wobei die Ofenwand von einer Ringleitung umgeben ist, in welcher der Heißwind geführt wird,
- wobei von der Ringleitung Stichleitungen abgehen, die an den Öffnungen der Ofenwand enden,
- wobei zumindest die Stichleitungen aus einem Stahlrohr bestehen, das innen mit einem Feuerfestmaterial ausgekleidet ist,
- wobei im Bereich der Öffnungen Injektionslanzen enden, mittels derer dem Heißwind Kohlestaub zugesetzt wird, so dass der Kohlestaub innerhalb des Prozessraums verbrennt,
- wobei den Stichleitungen Sensoreinrichtungen zur Beobachtung der Verbrennung des Kohlestaubs zugeordnet sind.

Aus der CN 202 881 302 U ist eine Sensoreinrichtung für einen Blas-Hochofen bekannt,
- wobei die Sensoreinrichtung eine Erfassungseinrichtung aufweist, mittels derer die Verbrennung von in den Prozessraum eingeblasenem Kohlestaub beobachtbar ist,
- wobei die Sensoreinrichtung eine mit der Erfassungseinrichtung datentechnisch verbundene Übermittlungseinrichtung aufweist, mittels derer Daten über die mittels der Erfassungseinrichtung beobachtete Verbrennung drahtlos aussendbar sind,
- wobei die Sensoreinrichtung einen thermoelektrischen Konverter aufweist, der an die Ofenwand thermisch angekoppelt ist und der aus der Temperaturdifferenz zwischen der Ofenwand und der Umgebung des Hochofens elektrische Energie erzeugt, mittels derer die Sensoreinrichtung mit elektrischer Energie versorgt wird.

Bei modernen Hochöfen wird unter anderem Kohlenstaub als Reduktionsmittel in den Prozessraum des Hochofens eingeblasen. Im englischen wird dies als PCI (= pulverized coal injection) bezeichnet. Das Einblasen erfolgt in der Regel über spezielle Düsen, in denen Heißwind mit dem Kohlenstoff vermischt und dem Prozessraum zugeführt wird. Mittels der PCI-Methode ist es möglich, den Leistungsbedarf des Hochofens zu optimieren und die Kosten signifikant zu senken.

Damit diese Methode ordnungsgemäß funktioniert, muss sichergestellt sein, dass der eingeblasene Kohlestaub an der Düsenspitze der Windform optimal verbrennt. Kann dies nicht gewährleistet werden, wird Kohlestaub in den Hochofenprozess eingebracht, der - wegen des Fehlens von Sauerstoff - nicht mehr reagieren kann. Weiterhin können diese Stäube auch die Luftkanäle innerhalb des Hochofens verstopfen, was in der Folge zu einer Senkung der Produktivität führen kann.

Um sicherzustellen, dass der Kohlestaub an der Düsenspitze der Windform ordnungsgemäß verbrennt, wird bei der WO 2009/ 141 419 A1 der Verbrennungsprozess überwacht. Die Überwachung kann mittels Drucksensoren, mittels Lichtintensitätssensoren oder über die Beobachtung des Flammbildes mittels einer Kamera erfolgen.

Die entsprechende Überwachungseinrichtung muss zum einen mit elektrischer Energie versorgt werden. Zum anderen müssen die von der Überwachungseinrichtung erfassten Daten an eine Prozesssteuerung für den Hochofen oder eine andere Einrichtung übermittelt werden. Im Falle einer Energieversorgung über eine Versorgungsleitung und eine Datenübermittlung über ein Datenkabel sind diese beiden Vorgänge (also die Energieversorgung und die Datenübermittlung) aufgrund der rauen Verhältnisse beim Betrieb des Hochofens störgefährdet. In der CN 202 881 302 U wird daher vorgeschlagen, ein sogenanntes energy harvesting durchzuführen, d.h. einen thermoelektrischen Konverter vorzusehen, der an zwei unterschiedlich warme Umgebungen angekoppelt wird und aufgrund der Temperaturdifferenz elektrische Energie erzeugt. Derartige thermoelektrische Konverter sind allgemein bekannt. Beispielsweise kann ein Peltierelement als derartiger Konverter verwendet werden. Weiterhin erfolgt bei der CN 202 881 302 U eine drahtlose Übertragung der erfassten Bilder.

Bei der CN 202 881 302 U ist der thermoelektrische Konverter in der Nähe der Windform an die Ofenwand angeschweißt. Diese Ausgestaltung erweist sich im praktischen Betrieb als umständlich und fehleranfällig.

Die Aufgabe der vorliegenden Erfindung besteht darin, bei einem Hochofen unter Beibehaltung des autarken Betriebs der Sensoreinrichtungen eine zuverlässigere und effiziente Energieversorgung der Sensoreinrichtungen zu gewährleisten.

Die Aufgabe wird durch einen Hochofen mit den Merkmalen des Anspruchs 1 gelöst. Vorteilhafte Ausgestaltungen des Hochofens sind Gegenstand der abhängigen Ansprüche 2 bis 13.

Erfindungsgemäß wird ein Hochofen derart ausgestaltet,
- dass der Hochofen eine schachtförmige Ofenwand aufweist, die einen Prozessraum umschließt, in dem Eisenerz zu Eisen verhüttet wird,
- dass die Ofenwand an ihrem Umfang Öffnungen aufweist, über welche dem Prozessraum Heißwind zugeführt wird,
- dass die Ofenwand von einer Ringleitung umgeben ist, in welcher der Heißwind geführt wird,
- dass von der Ringleitung Stichleitungen abgehen, die an den Öffnungen der Ofenwand enden,
- dass zumindest die Stichleitungen aus einem Stahlrohr bestehen, das innen mit einem Feuerfestmaterial ausgekleidet ist,
- dass im Bereich der Öffnungen Injektionslanzen enden, mittels derer dem Heißwind Kohlestaub zugesetzt wird, so dass der Kohlestaub innerhalb des Prozessraums verbrennt,
- dass den Stichleitungen Sensoreinrichtungen zur Beobachtung der Verbrennung des Kohlestaubs zugeordnet sind,
- dass die Sensoreinrichtungen jeweils eine Erfassungseinrichtung aufweisen, mittels derer die Verbrennung des dem Heißwind zugesetzten Kohlestaubs beobachtbar ist,
- dass die Sensoreinrichtungen jeweils eine mit der jeweiligen Erfassungseinrichtung datentechnisch verbundene Übermittlungseinrichtung aufweisen, mittels derer Daten über die mittels der jeweiligen Erfassungseinrichtung beobachtete Verbrennung drahtlos aussendbar sind,
- dass die Sensoreinrichtungen jeweils einen thermoelektrischen Konverter aufweisen, der an die jeweilige Stichleitung thermisch angekoppelt ist und der aus der Temperaturdifferenz zwischen der jeweiligen Stichleitung und der Umgebung des Hochofens elektrische Energie erzeugt, mittels derer die jeweilige Sensoreinrichtung mit elektrischer Energie versorgt wird, und
- dass das Stahlrohr der jeweiligen Stichleitung in einem Teilbereich eine Ausnehmung aufweist und der thermoelektrische Konverter im Bereich der Ausnehmung angeordnet ist.

Aufgrund der Anordnung des thermoelektrischen Konverters am Stahlrohr der jeweiligen Stichleitung wird eine kompakte, störsichere Ausgestaltung der Energieversorgung gewährleistet. Aufgrund des Umstands, dass das Stahlrohr die Ausnehmung aufweist, wird der thermoelektrische Konverter mit einer hohen (aber nicht kritischen) Temperaturdifferenz betrieben. Der thermoelektrische Konverter kann daher relativ viel elektrische Energie (im Bereich von einigen Watt) zur Verfügung stellen.

In der Erfindung weist das Feuerfestmaterial im Bereich der Ausnehmung eine Vertiefung auf, so dass eine resultierende Restdicke des Feuerfestmaterials im Bereich zwischen dem thermoelektrischen Konverter und dem in der jeweiligen Stichleitung geführten Heißwind kleiner als eine Normaldicke ist, welche das Feuerfestmaterial im übrigen Bereich aufweist. Dadurch kann die Temperaturdifferenz noch weiter erhöht werden. Die Restdicke kann insbesondere zwischen 50 % und 80 % der Normaldicke liegen.

Bei entsprechender Ausgestaltung des thermoelektrischen Konverters ist es möglich, dass der thermoelektrische Konverter direkt das Feuerfestmaterial kontaktiert, mit dem das Stahlrohr innen ausgekleidet ist. Dies gilt sowohl dann, wenn das Feuerfestmaterial im Bereich der Ausnehmung keine Vertiefung aufweist (also ausschließlich das Stahlrohr der jeweiligen Stichleitung die Ausnehmung aufweist), als auch dann, wenn das Feuerfestmaterial im Bereich der Ausnehmung die Vertiefung aufweist. In beiden Fällen ist es möglich, dass der thermoelektrische Konverter eine Ummantelung aus einem Metall - insbesondere Stahl - aufweist. In dem Fall, dass das Feuerfestmaterial die Vertiefung aufweist, ist jedoch im Bereich der Ausnehmung ein Zwischenelement angeordnet, das mit dem Stahlrohr gasdicht verbunden ist. In diesem Fall kontaktiert der thermoelektrische Konverter das Zwischenelement.

Zum Herstellen der gasdichten Verbindung mit dem Stahlrohr kann das Zwischenelement insbesondere mit dem Stahlrohr geschweißt sein.

Das Zwischenelement besteht in der Regel aus einem geeigneten Metall. Das Metall kann insbesondere Stahl sein.

In der Regel weisen die Stichleitungen jeweils einen ersten Abschnitt und einen an den jeweiligen ersten Abschnitt angrenzenden zweiten Abschnitt auf. Der erste Abschnitt grenzt an die Ringleitung an und verläuft, bezogen auf die Ringleitung, nach radial innen und nach unten. Der zweite Abschnitt verläuft horizontal und endet an der jeweiligen Öffnung der Ofenwand. Vorzugsweise ist der jeweilige thermoelektrische Konverter im ersten Abschnitt der jeweiligen Stichleitung angeordnet. Diese Ausgestaltung erweist sich zum einen als kompakt und zum anderen als besonders einfach realisierbar.

Oftmals sind die Erfassungseinrichtungen als Kameras ausgebildet, die eine jeweilige optische Achse - gegebenenfalls nach einer Strahlumlenkung - aufweisen, wobei die jeweilige optische Achse innerhalb des jeweiligen zweiten Abschnitts parallel zur Erstreckung des jeweiligen zweiten Abschnitts verläuft.

Es ist möglich, dass die Erfassung ausschließlich mittels der Kamera erfolgt.

Alternativ dazu ist es möglich, dass der Kamera eine optische Einrichtung vorgeordnet ist, mittels derer ein Bild der Verbrennung des dem Heißwind über die jeweilige Injektionslanze zugesetzten Kohlestaubs zumindest zeitweise alternativ oder zusätzlich zur Zuführung zur Kamera einem Okular zuführbar sind. Die optische Einrichtung kann beispielsweise als klappbarer Spiegel ausgebildet sein. In diesem Fall wird das Bild je nach Stellung des Spiegels alternativ zur Zuführung zur Kamera dem Okular zugeführt.

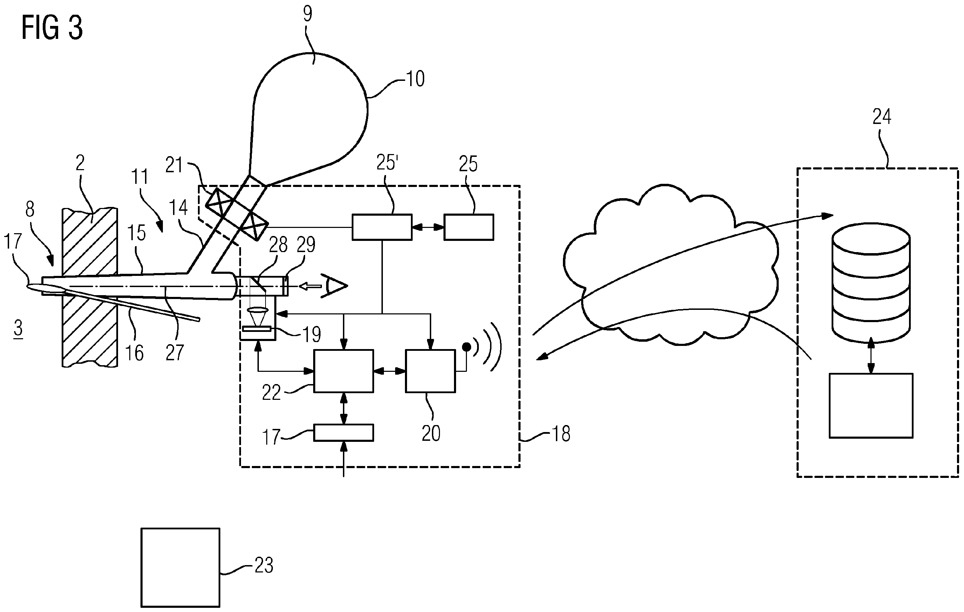

Alternativ zum klappbaren Spiegel kann die optische Einrichtung beispielsweise ein semitransparenter Spiegel oder ein sogenannter Strahlteilerwürfel sein. In diesem Fall wird das Bild zusätzlich zur Zuführung zur Kamera dem Okular zugeführt. Der semitransparente Spiegel bzw. der Strahlteilerwürfel müssen in diesem Fall nicht mechanisch bewegt werden; außerdem kann ein Bediener über das Okular die Verbrennung im Inneren des Hochofens beobachten, ohne dass dies die Überwachung mittels der Kamera beeinflussen würde. Typischerweise sind die optischen Achsen der Kamera und des Okulars um 90° versetzt (siehe z.B. FIG 3).

Die Art der drahtlosen Übermittlung kann nach Bedarf bestimmt sein. Insbesondere ist es möglich, dass die Übermittlungseinrichtungen auf dem GSM-, dem UMTS-, dem LTE- oder dem ISM-Standard basieren.

Es ist möglich, die mittels der jeweiligen Erfassungseinrichtung erfassten Daten so, wie sie sind, der Übermittlungseinrichtung zuzuführen. Vorzugsweise jedoch ist zwischen der jeweiligen Erfassungseinrichtung und der jeweiligen Übermittlungseinrichtung jeweils eine Auswertungseinrichtung angeordnet, welche die von der jeweiligen Erfassungseinrichtung erfassten Daten vor dem Zuführen zur Übermittlungseinrichtung auswertet. Dadurch kann insbesondere das Datenaufkommen reduziert werden, oftmals sogar deutlich reduziert.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: einen Längsschnitt durch einen Hochofen,
- FIG 2: einen Schnitt längs einer Linie II-II durch den Hochofen von FIG 1,
- FIG 3: ein Detail von FIG 3 sowie Kommunikationen und
- FIG 4: eine Stichleitung mit einem thermoelektrischen Konverter.

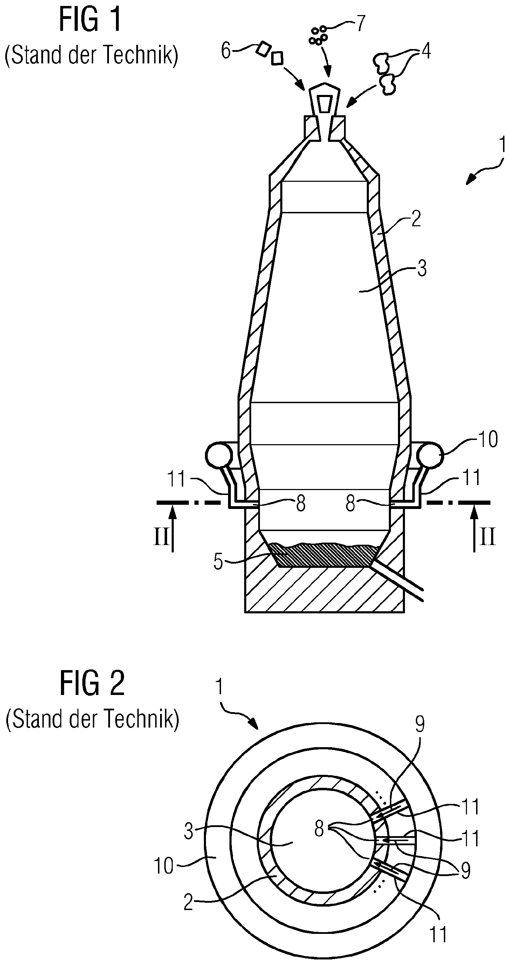

FIG 1 zeigt einen vom Ansatz her konventionell aufgebauten Hochofen 1. Der Hochofen 1 weist gemäß FIG 1 eine schachtförmige Ofenwand 2 auf. Die Ofenwand 2 umschließt einen Prozessraum 3. Im Prozessraum 3 wird Eisenerz 4 zu Eisen 5 verhüttet. Die Beschickung des Prozessraums 3 erfolgt in üblicher Weise von oben mit dem Eisenerz 4, Koks 6 sowie Zuschlagstoffen 7 wie beispielsweise Kalk.

Die Ofenwand 2 weist gemäß den FIG 1 und 2 an ihrem Umfang Öffnungen 8 auf. Die Anzahl an Öffnungen 8 liegt oftmals im mittleren zweistelligen Bereich, beispielsweise zwischen 30 und 50. Über die Öffnungen 8 wird dem Prozessraum 3 Heißwind 9 zugeführt. Bei dem Heißwind 9 handelt es sich im Regelfall um Luft. Alternativ kann es sich um mit Sauerstoff angereicherte Luft handeln.

Die Ofenwand 2 ist von einer Ringleitung 10 umgeben. In der Ringleitung 10 wird der Heißwind 9 geführt. Von der Ringleitung 10 gehen Stichleitungen 11 ab. Die Stichleitungen 11 enden an den Öffnungen 8 der Ofenwand 2. Für jede Öffnung 8 ist in der Regel eine eigene Stichleitung 11 vorhanden.

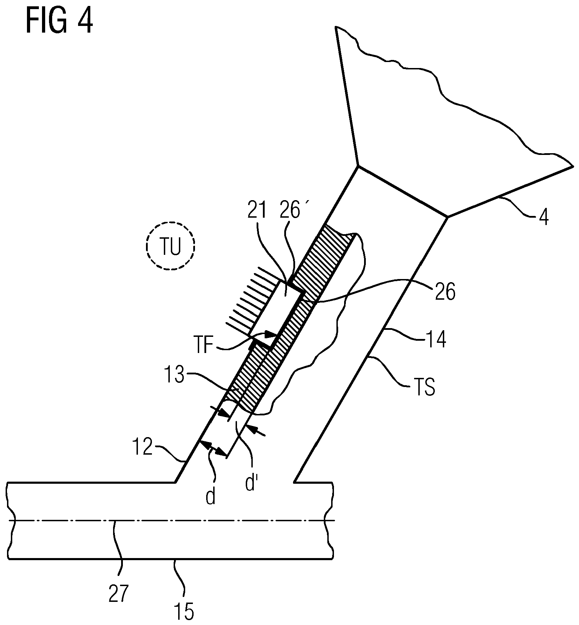

In Verbindung mit den FIG 3 und 4 wird nachfolgend der Aufbau einer einzelnen Stichleitung 11 näher erläutert. Die entsprechenden Aussagen sind in der Regel für alle Stichleitungen 11 gültig.

Gemäß FIG 4 besteht die Stichleitung 11 aus einem Stahlrohr 12, das innen mit einem Feuerfestmaterial 13 ausgekleidet ist. Weiterhin weist die Stichleitung 11 einen ersten Abschnitt 14 auf. Der erste Abschnitt 14 grenzt an die Ringleitung 10 an. Er verläuft, bezogen auf die Ringleitung 10, nach radial innen (also auf die Ofenwand 2 zu) und nach unten. Die Stichleitung 11 weist weiterhin einen zweiten Abschnitt 15 auf. Der zweite Abschnitt 15 grenzt an den ersten Abschnitt 14 an. Er verläuft (zumindest im wesentlichen) horizontal. Der zweite Abschnitt 15 endet an der entsprechenden Öffnung 8 der Ofenwand 2.

Im Bereich der entsprechenden Öffnung 8 endet weiterhin eine jeweilige Injektionslanze 16. Mittels der Injektionslanze 16 wird dem Heißwind 9 Kohlestaub 17 zugesetzt. Der Kohlestaub 17 wird von dem Heißwind 9 in den Prozessraum 3 eingeblasen. Der Kohlestaub 17 verbrennt dort. Im Rahmen der Verbrennung reduziert der verbrennende Kohlestaub 17 im Prozessraum 3 befindliches Eisenoxid zu Eisen.

Zur Beobachtung der Verbrennung des Kohlestaubs 17 ist der Stichleitung 11 eine Sensoreinrichtung 18 zugeordnet. Die Sensoreinrichtung 18 weist zumindest eine Erfassungseinrichtung 19, eine Übermittlungseinrichtung 20 und einen thermoelektrischen Konverter 21 auf.

Mittels der Erfassungseinrichtung 19 wird die Verbrennung des dem Heißwind 9 zugesetzten Kohlestaubs 17 beobachtet.

Die Übermittlungseinrichtung 20 ist (direkt oder über eine Auswertungseinrichtung 22) datentechnisch mit der Erfassungseinrichtung 19 verbunden. Mittels der Übermittlungseinrichtung 20 werden Daten über die mittels der Erfassungseinrichtung 19 beobachtete Verbrennung des Kohlestaubs 17 ausgesendet. Das Aussenden erfolgt drahtlos. Die Übermittlungseinrichtung 20 kann zu diesem Zweck beispielsweise auf dem GSM-, dem UMTS-, dem LTE- oder dem ISM-Standard basieren. Die Übermittlung kann beispielsweise an eine Prozesssteuerung 23 des Hochofens 1 oder an eine Recheneinheit 24 erfolgen.

Der thermoelektrische Konverter 21 ist an die Stichleitung 11 thermisch angekoppelt. Der thermoelektrische Konverter 21 ist zu diesem Zweck vorzugsweise im ersten Abschnitt 14 der Stichleitung 11 angeordnet. Der thermoelektrische Konverter 21 erzeugt aus der Temperaturdifferenz zwischen der jeweiligen Stichleitung 11 und der Umgebung des Hochofens 1 elektrische Energie. Der thermoelektrische Konverter 21 versorgt mit der von ihm erzeugten elektrischen Energie die übrigen Komponenten der Sensoreinrichtung 18, also insbesondere die Erfassungseinrichtung 19 und die Übermittlungseinrichtung 20 sowie, falls vorhanden, auch die Auswertungseinrichtung 22. Der thermoelektrische Konverter 21 kann beispielsweise als Peltierelement ausgebildet sein. Dem thermoelektrischen Konverter 21 kann weiterhin ein Energiepuffer 25 zugeordnet sein, beispielsweise ein Akkumulator oder ein Superkondensator. Soweit erforderlich, kann weiterhin ein Laderegler 25' vorhanden sein.

Zur Optimierung der Energiegewinnung ist vorgesehen, dass das Stahlrohr 12 der Stichleitung 11 in einem Teilbereich eine Ausnehmung 26 aufweist. Dort - also im Bereich der Ausnehmung 26 - ist der thermoelektrische Konverter 21 angeordnet.

Der thermoelektrische Konverter 21 kann unter Umständen direkt (d.h. ohne Mitwirkung des Stahlrohres 12) das Feuerfestmaterial 13, mit dem das Stahlrohr 12 innen ausgekleidet ist, kontaktieren.

Gemäß der in FIG 4 dargestellten bevorzugten Ausgestaltung weist das Feuerfestmaterial 13 im Bereich der Ausnehmung 26 weiterhin eine Vertiefung auf. Eine resultierende Restdicke d', die das Feuerfestmaterial 13 im Bereich zwischen dem thermoelektrischen Konverter 21 und dem in der jeweiligen Stichleitung 11 geführten Heißwind 9 aufweist, ist daher kleiner als eine Normaldicke d, welche das Feuerfestmaterial 13 im übrigen Bereich aufweist. Die Restdicke d' kann insbesondere zwischen 50 % und 80 % der Normaldicke d liegen.

Die Ausgestaltung von FIG 4 bewirkt, dass die Erzeugung elektrischer Energie durch den thermoelektrischen Konverter 21 nicht auf der Differenz zwischen der Umgebungstemperatur TU und der Temperatur TS des Stahlrohres 12 basiert, sondern auf der Differenz zwischen der Umgebungstemperatur TU und der (dort gegebenen) Temperatur TF des Feuerfestmaterials 13. Insbesondere ist die Temperatur TF des Feuerfestmaterials 13 oftmals erheblich größer als die Temperatur TS des Stahlrohres 12. Beispielsweise kann die Temperatur TF bei ca. 250 °C liegen, die des Stahlrohres 12 bei ca. 70 °C. Da die Umgebungstemperatur TU bei ca. 25 °C liegt, ist die Temperaturdifferenz zwischen Feuerfestmaterial 13 und Umgebung rund fünfmal so groß wie die Temperaturdifferenz zwischen Stahlrohr 12 und Umgebung. Da weiterhin die vom thermoelektrischen Konverter 21 generierte elektrische Energie proportional zur Temperaturdifferenz ist, kann der thermoelektrische Konverter 21 (bei ansonsten gleicher Auslegung) die fünffache Menge an elektrischer Energie liefern.

Auch im Rahmen dieser Ausgestaltung (also des Vorhandenseins der Vertiefung im Feuerfestmaterial 13) kann der thermoelektrische Konverter 21 unter Umständen das Feuerfestmaterial 13 direkt kontaktieren. In der Regel ist jedoch im Bereich der Ausnehmung 26 ein Zwischenelement 26' angeordnet ist, das mit dem Stahlrohr 12 gasdicht verbunden ist. Der thermoelektrische Konverter 21 kontaktiert in diesem Fall das Zwischenelement 26'.

Die gasdichte Verbindung des Zwischenelements 26' mit dem Stahlrohr 12 kann beispielsweise dadurch erreicht werden, dass das Zwischenelement 26' mit dem Stahlrohr 12 geschweißt ist. Alternativ kann das Zwischenelement 26' an das Stahlrohr 12 angeschraubt sein, wobei zusätzlich zwischen dem Zwischenelement 26' und dem Stahlrohr 12 ein Dichtungselement angeordnet ist, beispielsweise ein O-Ring.

Das Zwischenelement 26' besteht aus einem mechanisch hinreichend stabilen, thermisch relativ gut leitenden Material. In der Regel besteht das Zwischenelement 26' aus Stahl.

Gemäß FIG 3 ist die Erfassungseinrichtung 19 als Kamera ausgebildet. Insbesondere kann die Kamera als Thermokamera (= Wärmebildkamera) ausgebildet sein. Die Kamera weist eine optische Achse 27 auf. Die optische Achse 27 verläuft nach einer Strahlenumlenkung innerhalb des zweiten Abschnitts 15 parallel zur Erstreckung des zweiten Abschnitts 15. Gemäß FIG 3 ist der Kamera weiterhin eine optische Einrichtung 28 vorgeordnet, gemäß der Darstellung in FIG 3 ein Spiegel. Mittels der optischen Einrichtung 28 ist ein Bild der Verbrennung des dem Heißwind 9 über die Injektionslanze 16 zugesetzten Kohlestaubs 17 einem Okular 29 zuführbar. Je nach Ausgestaltung der optischen Einrichtung 28 als Spiegel, als semitransparenter Spiegel oder als Strahlteilerwürfel erfolgt das Zuführen zum Okular 29 alternativ oder zusätzlich zur Zuführung zur Kamera. Im Falle der alternativen Zuführung zur Kamera erfolgt das Zuführen nur temporär. Anderenfalls kann es - wie dargestellt - permanent erfolgen. Gemäß FIG 3 ist daher parallel zu einer automatisierten Überwachung durch die Sensoreinrichtungen 18 auch möglich, dass ein Mensch direkt das Flammbild beobachtet. Die optischen Achsen der Kamera und des Okulars 29 weisen in diesem Fall einen Versatz von 90° zueinander auf.

Falls die Auswertungseinrichtung 22 vorhanden ist, ist sie in datentechnischer Hinsicht zwischen der Erfassungseinrichtung 19 und der Übermittlungseinrichtung 20 angeordnet. Die Auswertungseinrichtung 22 wertet die von der Erfassungseinrichtung 19 erfassten Daten vor dem Zuführen zur Übermittlungseinrichtung 20 aus. Beispielsweise kann die Auswertungseinrichtung 22 eine mittlere Helligkeit der von der Kamera erfassten Bilder ermitteln oder beispielsweise nur jedes x-te Bild (x = 2, 3, 4, ...20, ..., 50, ...100, ...) an die Übermittlungseinrichtung 20 weitergeben oder nur dann ein Bild an die Übermittlungseinrichtung 20 weitergeben, wenn das erfasste Bild als kritisch bewertet wird, beispielsweise weil die zu beobachtende Flamme erloschen ist. Auch kann nach jeweils wenigen Sekunden jeweils ein neues Bild an die Übermittlungseinrichtung 20 weitergegeben werden. Sofern die nötige Bandbreite zur Verfügung steht, kann jedoch auch ein Livestream an Videodaten gesendet werden. Auch andere Vorgehensweisen sind selbstverständlich möglich. Beispielsweise kann die Auswertungseinrichtung 22 erfasste Bilder puffern, bevor sie an die Übermittlungseinrichtung 20 weitergegeben werden. Auch ist es möglich, dass die Auswertungseinrichtung 22 nur von Zeit zu Zeit einen Livestream an Videodaten an die Übermittlungseinrichtung 20 weitergibt, zum Beispiel nur dann für jeweils wenige Sekunden, wenn ein Bild als kritisch beurteilt wurde.

Soweit erforderlich, können mittels der Sensoreinrichtungen 18 auch weitere Daten erfasst werden, beispielsweise der Druck am Anfang der jeweiligen Stichleitung 11 oder der Druckabfall in der Stichleitung 11 oder die Menge an dem Heißwind 9 durch die jeweilige Injektionslanze 6 zugesetztem Kohlestaub 17. Auch diese Daten können gegebenenfalls der jeweiligen Übermittlungseinrichtung 20 zugeführt und von dieser drahtlos ausgesendet werden. Weiterhin ist es alternativ möglich, derartige Daten mittels der Prozesssteuerung 23 zu erfassen und an die Recheneinheit 24 zu übermitteln. Die Übermittlung an die Recheneinheit 24 kann direkt von der Prozesssteuerung 23 aus erfolgen. Alternativ ist es möglich, dass die Prozesssteuerung 23 die Daten zunächst drahtlos an die jeweils betroffene Sensoreinrichtung 18 übermittelt und die jeweilige Sensoreinrichtung 18 die Daten weiter an die Recheneinheit 24 übermittelt.

Zusammengefasst betrifft die vorliegende Erfindung somit folgenden Sachverhalt:
Ein Hochofen 1 weist eine schachtförmige Ofenwand 2 auf, die einen Prozessraum 3 umschließt, in dem Eisenerz 4 zu Eisen 5 verhüttet wird. Die Ofenwand 2 weist an ihrem Umfang Öffnungen 8 auf, über welche dem Prozessraum 3 Heißwind 9 zugeführt wird. Die Ofenwand 2 ist von einer Ringleitung 10 umgeben, in welcher der Heißwind 9 geführt wird. Von der Ringleitung 10 gehen Stichleitungen 11 ab, die an den Öffnungen 8 der Ofenwand 2 enden. Zumindest die Stichleitungen 11 bestehen aus Stahlrohr 12, das innen mit einem Feuerfestmaterial 13 ausgekleidet ist. Im Bereich der Öffnungen 8 enden Injektionslanzen 16, mittels derer dem Heißwind 9 Kohlestaub 17 zugesetzt wird, der innerhalb des Prozessraums 3 verbrennt. Den Stichleitungen 11 zugeordnete Sensoreinrichtungen 19 weisen Erfassungseinrichtungen 19 auf, mittels derer die Verbrennung des Kohlestaubs 17 beobachtet wird. Sie weisen weiterhin mit den Erfassungseinrichtungen 19 datentechnisch verbundene Übermittlungseinrichtungen 20 auf, mittels derer Daten über die beobachteten Verbrennungen drahtlos aussendbar sind. Die Sensoreinrichtungen 18 weisen ferner thermoelektrische Konverter 21 auf, die an die Stichleitungen 11 thermisch angekoppelt sind und die aus der Temperaturdifferenz zwischen den Stichleitungen 11 und der Umgebung des Hochofens 1 elektrische Energie erzeugen, mittels derer die Sensoreinrichtungen 18 mit elektrischer Energie versorgt werden. Die Stahlrohre 12 der Stichleitungen 11 weisen in Teilbereichen Ausnehmungen 26 auf. Dort sind die thermoelektrischen Konverter 21 angeordnet.

Insbesondere durch die drahtlose Übermittlung der mittels der Erfassungseinrichtungen 19 erfassten Daten ergibt sich eine Vielzahl von Vorteilen. So ist es beispielsweise möglich, das Flammbild permanent zu erfassen und ebenso permanent oder alternativ diskontinuierlich über die Übermittlungseinrichtungen 20 auszusenden. Der zugehörige Empfänger kann beispielsweise die bereits erwähnte Recheneinheit 24 sein. Dort können die erfassten und übermittelten Bilder einzeln für jede Sensoreinrichtung 18 oder auch übergreifend über die Sensoreinrichtungen 18 des Hochofens 1 oder sogar übergreifend über mehrere Hochöfen ausgewertet werden. Aufgrund der Auswertung können beispielsweise optimierte Sollwerte ermittelt werden, welche für den zukünftigen Betrieb der Prozesssteuerung 23 zur Verfügung gestellt werden. Zu diesem Zweck kann eine drahtlose oder drahtgebundene Verbindung zwischen der Prozesssteuerung 23 und der Recheneinheit 24 bestehen. Vorzugsweise erfolgt hierbei keine direkte und unmittelbare Übernahme neu übermittelter Sollwerte, sondern nur eine Ausgabe an einen Bediener als zu übernehmender Vorschlag. Der Bediener kann diesen Vorschlag dann annehmen oder ablehnen. Auch ist es möglich, dass - beispielsweise durch eine intellektuelle Auswertung durch einen Menschen - auf Seiten der Recheneinheit 24 die erfassten und übermittelten Bilder im Rahmen der Projektierung und Planung zukünftiger Hochöfen berücksichtigt werden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung gemäß den Ansprüchen zu verlassen.

### Bezugszeichenliste

- 1: Hochofen
- 2: Ofenwand
- 3: Prozessraum
- 4: Eisenerz
- 5: Eisen
- 6: Koks
- 7: Zuschlagstoffe
- 8: Öffnungen
- 9: Heißwind
- 10: Ringleitung
- 11: Stichleitungen
- 12: Stahlrohr
- 13: Feuerfestmaterial
- 14: erster Abschnitt
- 15: zweiter Abschnitt
- 16: Injektionslanze
- 17: Kohlestaub
- 18: Sensoreinrichtung
- 19: Erfassungseinrichtung
- 20: Übermittlungseinrichtung
- 21: thermoelektrischer Konverter
- 22: Auswertungseinrichtung
- 23: Prozesssteuerung
- 24: Recheneinheit
- 25: Energiepuffer
- 25': Laderegler
- 26: Ausnehmung
- 26': Zwischenelement
- 27: optische Achse
- 28: optische Einrichtung
- 29: Okular

- d, d': Dicken
- TF, TS, TU: Temperaturen

## Patentansprüche

1. Hochofen,
- wobei der Hochofen eine schachtförmige Ofenwand (2) aufweist, die einen Prozessraum (3) umschließt, in dem Eisenerz (4) zu Eisen (5) verhüttet wird,
- wobei die Ofenwand (2) an ihrem Umfang Öffnungen (8) aufweist, über welche dem Prozessraum (3) Heißwind (9) zugeführt wird,
- wobei die Ofenwand (2) von einer Ringleitung (10) umgeben ist, in welcher der Heißwind (9) geführt wird,
- wobei von der Ringleitung (10) Stichleitungen (11) abgehen, die an den Öffnungen (8) der Ofenwand (2) enden,
- wobei zumindest die Stichleitungen (11) aus einem Stahlrohr (12) bestehen, das innen mit einem Feuerfestmaterial (13) ausgekleidet ist,
- wobei im Bereich der Öffnungen (8) Injektionslanzen (16) enden, mittels derer dem Heißwind (9) Kohlestaub (17) zugesetzt wird, so dass der Kohlestaub (17) innerhalb des Prozessraums (3) verbrennt,
- wobei den Stichleitungen (11) Sensoreinrichtungen (18) zur Beobachtung der Verbrennung des Kohlestaubs (17) zugeordnet sind,
- wobei die Sensoreinrichtungen (18) jeweils eine Erfassungseinrichtung (19) aufweisen, mittels derer die Verbrennung des dem Heißwind (9) zugesetzten Kohlestaubs (17) beobachtbar ist,
- wobei die Sensoreinrichtungen (18) jeweils eine mit der jeweiligen Erfassungseinrichtung (19) datentechnisch verbundene Übermittlungseinrichtung (20) aufweisen, mittels derer Daten über die mittels der jeweiligen Erfassungseinrichtung (19) beobachtete Verbrennung drahtlos aussendbar sind,
- wobei die Sensoreinrichtungen (18) jeweils einen thermoelektrischen Konverter (21) aufweisen, der an die jeweilige Stichleitung (11) thermisch angekoppelt ist und der aus der Temperaturdifferenz zwischen der jeweiligen Stichleitung (11) und der Umgebung des Hochofens elektrische Energie erzeugt, mittels derer die jeweilige Sensoreinrichtung (18) mit elektrischer Energie versorgt wird, und
- wobei das Stahlrohr (12) der jeweiligen Stichleitung (11) in einem Teilbereich eine Ausnehmung (26) aufweist und der thermoelektrische Konverter (21) im Bereich der Ausnehmung (26) angeordnet ist, wobei
das Feuerfestmaterial (13) im Bereich der Ausnehmung (26) eine Vertiefung aufweist, so dass eine resultierende Restdicke (d') des Feuerfestmaterials (13) im Bereich zwischen dem thermoelektrischen Konverter (21) und dem in der jeweiligen Stichleitung (11) geführten Heißwind (9) kleiner als eine Normaldicke (d) ist, welche das Feuerfestmaterial (13) im übrigen Bereich aufweist, wobei im Bereich der Ausnehmung (26) ein Zwischenelement (26') angeordnet ist, das mit dem Stahlrohr (12) gasdicht verbunden ist und dass der thermoelektrische Konverter (21) das Zwischenelement (26') kontaktiert.

2. Hochofen nach Anspruch 1,
**dadurch gekennzeichnet,**
**dass** die Restdicke (d') zwischen 50 % und 80 % der Normaldicke (d) liegt.
**dass**

3. Hochofen nach Anspruch 1,
**dadurch gekennzeichnet,**
**dass** das Zwischenelement (26') mit dem Stahlrohr (12) geschweißt ist.

4. Hochofen nach Anspruch 1,
**dadurch gekennzeichnet,**
**dass** das Zwischenelement (26') an das Stahlrohr (12) angeschraubt ist und dass zwischen dem Zwischenelement (26') und dem Stahlrohr (12) ein Dichtungselement angeordnet ist.

5. Hochofen nach Anspruch 1, 3 oder 4,
**dadurch gekennzeichnet,**
**dass** das Zwischenelement (26') aus Stahl besteht.

6. Hochofen nach Anspruch 1, 2, 3 oder 4,
**dadurch gekennzeichnet,**
- **dass** die Stichleitungen (11) jeweils einen ersten Abschnitt (14) und einen an den jeweiligen ersten Abschnitt (14) angrenzenden zweiten Abschnitt (15) aufweisen,
- **dass** der erste Abschnitt (14) an die Ringleitung (10) angrenzt und, bezogen auf die Ringleitung (10), nach radial innen und nach unten verläuft und
- **dass** der zweite Abschnitt (15) horizontal verläuft und an der jeweiligen Öffnung (8) der Ofenwand (2) endet.

7. Hochofen nach Anspruch 6,
**dadurch gekennzeichnet,**
**dass** der jeweilige thermoelektrische Konverter (21) im ersten Abschnitt (14) der jeweiligen Stichleitung (11) angeordnet ist.

8. Hochofen nach Anspruch 6 oder 7,
**dadurch gekennzeichnet,**
**dass** die Erfassungseinrichtungen (19) als Kameras ausgebildet sind, die eine jeweilige optische Achse (27) aufweisen und dass die jeweilige optische Achse (27), gegebenenfalls nach einer Strahlumlenkung - innerhalb des jeweiligen zweiten Abschnitts (15) parallel zur Erstreckung des jeweiligen zweiten Abschnitts (15) verläuft.

9. Hochofen nach Anspruch 8,
**dadurch gekennzeichnet,**
**dass** der Kamera eine optische Einrichtung (28) vorgeordnet ist, mittels derer ein Bild der Verbrennung des dem Heißwind (9) über die jeweilige Injektionslanze (16) zugesetzten Kohlestaubs (17) zumindest zeitweise alternativ oder zusätzlich zur Zuführung zur Kamera einem Okular (29) zuführbar ist.

10. Hochofen nach Anspruch 9,
**dadurch gekennzeichnet,**
**dass** die optischen Achsen der Kamera (19) und es Okulars (29) einen Versatz von 90° zueinander ausweisen.

11. Hochofen nach einem der obigen Ansprüche,
**dadurch gekennzeichnet,**
**dass** die Übermittlungseinrichtungen (20) auf dem GSM-, dem UMTS-, dem LTE- oder dem ISM-Standard basieren.

12. Hochofen nach einem der obigen Ansprüche,
**dadurch gekennzeichnet,**
**dass** zwischen der jeweiligen Erfassungseinrichtung (19) und der jeweiligen Übermittlungseinrichtung (20) jeweils eine Auswertungseinrichtung (22) angeordnet ist, welche die von der jeweiligen Erfassungseinrichtung (19) erfassten Daten vor dem Zuführen zur Übermittlungseinrichtung (20) auswertet.

## Claims

1. Blast furnace,
- wherein the blast furnace has a shaft-like furnace wall (2) which encloses a process chamber (3) in which iron ore (4) is smelted to form iron (5),
- wherein the furnace wall (2) has, on its circumference, openings (8) via which hot blast (9) is fed to the process chamber (3),
- wherein the furnace wall (2) is surrounded by a ring line (10) in which the hot blast (9) is conducted,
- wherein branch lines (11) extend from the ring line (10), which branch lines end at the openings (8) of the furnace wall (2),
- wherein at least the branch lines (11) are composed of a steel pipe (12) which is lined on the inside with a fire-resistant material (13),
- wherein injection lances (16) end in the region of the openings (8), by means of which injection lances coal dust (17) is added to the hot blast (9), such that the coal dust (17) is burned within the process chamber (3),
- wherein the branch lines (11) are assigned sensor devices (18) for observing the combustion of the coal dust (17),
- wherein the sensor devices (18) each have a detection device (19) by means of which the combustion of the coal dust (17) added to the hot blast (9) can be observed,
- wherein the sensor devices (18) each have a transmission device (20) which is connected in terms of data transmission to the respective detection device (19) and by means of which data relating to the combustion observed by means of the respective detection device (19) can be wirelessly transmitted,
- wherein the sensor devices (18) each have a thermoelectric converter (21) which is thermally coupled to the respective branch line (11) and which generates electrical energy from the temperature difference between the respective branch line (11) and the surroundings of the blast furnace, by means of which electrical energy the respective sensor device (18) is supplied with electrical energy, and
- wherein the steel pipe (12) of the respective branch line (11) has a recess (26) in a partial region, and the thermoelectric converter (21) is arranged in the region of the recess (26), wherein
the fire-resistant material (13) has, in the region of the recess (26), a depression such that a resulting residual thickness (d') of the fire-resistant material (13) in the region between the thermoelectric converter (21) and the hot blast (9) conducted in the respective branch line (11) is smaller than a normal thickness (d) that the fire-resistant material (13) has in the remaining region, wherein, in the region of the recess (26), there is arranged an intermediate element (26') which is connected in gas-tight fashion to the steel pipe (12), and in that the thermoelectric converter (21) makes contact with the intermediate element (26').

2. Blast furnace according to Claim 1,
**characterized**
**in that** the residual thickness (d') lies between 50% and 80% of the normal thickness (d).

3. Blast furnace according to Claim 1,
**characterized**
**in that** the intermediate element (26') is welded to the steel pipe (12).

4. Blast furnace according to Claim 1,
**characterized**
**in that** the intermediate element (26') is screwed to the steel pipe (12), and in that a seal element is arranged between the intermediate element (26') and the steel pipe (12).

5. Blast furnace according to Claim 1, 3 or 4,
**characterized**
**in that** the intermediate element (26') is composed of steel.

6. Blast furnace according to Claim 1, 2, 3 or 4, **characterized**
- **in that** the branch lines (11) each have a first portion (14) and a second portion (15) adjoining the respective first portion (14),
- **in that** the first portion (14) adjoins the ring line (10) and, in relation to the ring line (10), runs radially inward and outward, and
- **in that** the second portion (15) runs horizontally and ends at the respective opening (8) of the furnace wall (2).

7. Blast furnace according to Claim 6,
**characterized**
**in that** the respective thermoelectric converter (21) is arranged in the first portion (14) of the respective branch line (11).

8. Blast furnace according to Claim 6 or 7,
**characterized**
**in that** the detection devices (19) are in the form of cameras which have a respective optical axis (27), and in that the respective optical axis (27), possibly after a beam diversion, runs parallel to the extent of the respective second portion (15) within the respective second portion (15).

9. Blast furnace according to Claim 8,
**characterized**
**in that**, in front of the camera, there is positioned an optical device (28) by means of which an image of the combustion of the coal dust (17) added to the hot blast (9) via the respective injection lance (16) can at least intermittently be supplied to an eyepiece (29) instead of or as well as being supplied to the camera.

10. Blast furnace according to Claim 9,
**characterized**
**in that** the optical axes of the camera (19) and of the eyepiece (29) have an offset of 90° with respect to one another.

11. Blast furnace according to any of the preceding claims,
**characterized**
**in that** the transmission devices (20) are based on the GSM, the UMTS, the LTE or the ISM standard.

12. Blast furnace according to any of the preceding claims,
**characterized**
**in that**, between the respective detection device (19) and the respective transmission device (20), there is arranged in each case one evaluation device (22) which evaluates the data detected by the respective detection device (19) before said data are supplied to the transmission device (20).

## Revendications

1. Haut-fourneau,
- dans lequel le haut-fourneau présente une paroi de four (2) en forme de cheminée, qui renferme un espace de traitement (3) dans lequel du minerai de fer (4) est soumis à une transformation sidérurgique pour obtenir du fer (5) ;
- dans lequel la paroi de four (2) présente, sur sa périphérie, des ouvertures (8) par lesquelles du vent chaud (9) est acheminé à l'espace de traitement (3) ;
- dans lequel la paroi de four (2) est entourée par un conduit annulaire (10) dans lequel est guidé le vent chaud (9) ;
- dans lequel, à partir du conduit annulaire (10), s'écartent des conduits de coulée (11) qui aboutissent contre les ouvertures (8) de la paroi de four (2) ;
- dans lequel au moins les conduits de coulée (11) sont constitués d'un tube en acier (12) qui est tapissé à l'intérieur avec un matériau réfractaire (13) ;
- dans lequel, dans la zone des ouvertures (8), aboutissent des lances d'injection (16) au moyen desquelles de la poussière de charbon (17) est ajoutée au vent chaud (9), d'une manière telle que la poussière de charbon (17) est soumise à une combustion à l'intérieur de l'espace de traitement (3) ;
- dans lequel des dispositifs de détection (18) pour l'observation de la combustion de la poussière de charbon (17) sont attribués aux conduits de coulée (11) ;
- dans lequel les dispositifs de détection (18) présentent respectivement un dispositif capteur (19) au moyen duquel la combustion de la poussière de charbon (17) ajoutée au vent chaud (9) peut être observée ;
- dans lequel les dispositifs de détection (18) présentent respectivement un dispositif de transmission (20) relié via une technique de transmission de données au dispositif capteur respectif (19), au moyen duquel des données peuvent être émises sans fil concernant la combustion observée au moyen du dispositif capteur respectif (19) ;
- dans lequel les dispositifs de détection (18) présentent respectivement un convertisseur thermoélectrique (21) qui est couplé par voie thermique au conduit de coulée respectif (11) et qui génère de l'énergie électrique à partir de la différence de température entre le conduit de coulée respectif (11) et l'environnement du haut-fourneau, convertisseur au moyen duquel le dispositif de détection respectif (18) est alimenté en énergie électrique ; et
- dans lequel le tube en acier (12) du conduit de coulée respectif (11) présente un évidement (26) dans une zone partielle et le convertisseur thermoélectrique (21) est disposé dans la zone de l'évidement (26) ; dans lequel
la matière réfractaire (13) présente, dans la zone de l'évidement (26), un renfoncement, d'une manière telle qu'une épaisseur résiduelle résultante (d') de la matière réfractaire (13) dans la zone entre le convertisseur thermoélectrique (21) et le vent chaud (9) guidé dans le conduit de coulée respectif (11) est inférieure à une épaisseur normale (d), que présente la matière réfractaire (13) dans la zone restante ; dans lequel, dans la zone de l'évidement (26), est disposé un élément intermédiaire (26') qui est relié au tube en acier (12) d'une manière étanche aux gaz ; et d'une manière telle que le convertisseur thermoélectrique (21) entre en contact avec l'élément intermédiaire (26').

2. Haut-fourneau selon la revendication 1, **caractérisé en ce que** l'épaisseur résiduelle (d') représente entre 50 % et 80 % de l'épaisseur normale (d).

3. Haut-fourneau selon la revendication 1, **caractérisé en ce que** l'élément intermédiaire (26') est soudé au tube en acier (12) .

4. Haut-fourneau selon la revendication 1, **caractérisé en ce que** l'élément intermédiaire (26') est vissé au tube en acier (12) et, **en ce que**, entre l'élément intermédiaire (26') et le tube en acier (12), est disposé un élément d'étanchéité.

5. Haut-fourneau selon la revendication 1, 3 ou 4, **caractérisé en ce que** l'élément intermédiaire (26') est constitué d'acier.

6. Haut-fourneau selon la revendication 1, 2, 3 ou 4, **caractérisé :**
- **en ce que** les conduits de coulée (11) présentent respectivement un premier tronçon (14) et un deuxième tronçon (15) adjacent au premier tronçon respectif (14) ;
- **en ce que** le premier tronçon (14) est adjacent au conduit annulaire (10) et, par rapport au conduit annulaire (10), s'étend en direction radiale vers l'intérieur et vers le bas ; et
- **en ce que** le deuxième tronçon (15) s'étend en direction horizontale et se termine contre l'ouverture respective (8) de la paroi de four (2).

7. Haut-fourneau selon la revendication 6, **caractérisé en ce que** le convertisseur thermoélectrique respectif (21) est disposé dans le premier tronçon (14) du conduit de coulée respectif (11).

8. Haut-fourneau selon la revendication 6 ou 7, **caractérisé en ce que** les dispositifs capteur (19) sont réalisés sous la forme de caméras qui présentent un axe optique respectif (27), et **en ce que** l'axe optique respectif (27), le cas échéant après une déviation du rayon à l'intérieur du deuxième tronçon respectif (15), s'étend parallèlement à l'étendue du deuxième tronçon respectif (15).

9. Haut-fourneau selon la revendication 8, **caractérisé en ce qu'**un dispositif optique (28) est monté en amont de la caméra, au moyen duquel une image de la combustion de la poussière de charbon (17) ajoutée au vent chaud (9) via la lance d'injection respective (16) peut être acheminé en variante de façon temporaire ou de manière supplémentaire à un oculaire (29) à des fins d'acheminement à la caméra.

10. Haut-fourneau selon la revendication 9, **caractérisé en ce que** les axes optiques de la caméra (19) et de l'oculaire (29) présentent un décalage de 90° l'un par rapport à l'autre.

11. Haut-fourneau selon l'une quelconque des revendications ci-dessus, **caractérisé en ce que** les dispositifs de transmission (20) se basent sur le standard GSM, le standard UMTS, le standard LTE ou le standard ISM.

12. Haut-fourneau selon l'une quelconque des revendications ci-dessus, **caractérisé en ce que**, entre le dispositif capteur respectif (19) et le dispositif de transmission respectif (20), est disposé respectivement un dispositif d'évaluation (22) qui évalue les données enregistrées par l'intermédiaire du dispositif capteur respectif (19) avant leur acheminement au dispositif de transmission (20).
